# EUROPEAN PATENT SPECIFICATION

(11) **EP 0 947 391 B1**
(45) Date of publication and mention of the grant of the patent: **21.12.2005**
(21) Application number: 99200614.8
(22) Date of filing: 03.03.1999
(51) Int. Cl.: B60R 16/02

(54) **Electrical distribution system**
Elektrisches Verteilungssystem
Système de distribution électrique

(30) Priority: 30.03.1998 GB 9806750
(43) Date of publication of application: 06.10.1999
(73) Proprietor: Delphi Technologies, Inc., Troy, MI 48007 (US)
(72) Inventor: Neibecker, Niels, 50769 Köln (DE); Stein, Thomas, 56271 Kleinmaischeid (DE); Hold, Klaus, 42289 Wuppertal (DE); Stadler, Peter, 57482 Wenden (DE)
(74) Representative: Denton, Michael John

(56) References cited:
- EP-A- 0 900 700
- DE-A- 19 724 254
- GB-A- 2 161 333
- US-A- 5 040 097
- US-A- 5 310 353
- US-A- 5 581 130

## Description

### Technical Field

The present invention relates to an electrical distribution system for a motor vehicle which is used for the distribution of both electrical power and electrical signals.

### Background of the Invention

Currently, in motor vehicles, electrical power distribution and electrical signal distribution are in general isolated from one another, and/or are provided by numerous separate systems. This leads to complicated wiring harness designs, difficulties in installation in the motor vehicle, and a multitude of system casings and set-ups. GB-A-2161333 describes a power distribution box for a motor vehicle having a board with fuses and relay connections. US-A-5040097 discloses a central system including a casing provided with connection means and enclosing a microcomputer which unifies controlling functions for all electrical loads. The microcomputer is separate from exchangeable switching devices.

The document EP 0 900 700 is a state of the art according to Art. 54 (3) and (4) EPC. This document discloses: An electrical distribution system for a motor vehicle comprising a power distribution board having an electrical connection means for connection to a power supply and to one or more electrical loads; a switch card extending away from, and electrically connectable with, the power distribution board, and having electrically operable switch means mounted thereon for switching the power supplied to the or each electrical load from the power supply; a control card extending away from, and electrically connectable with, the power distribution board, having an electrical connection means thereon for receiving and transmitting electrical signals, and having control means mounted thereon for controlling the operation of the switch means dependent on signals received at the electrical connection means on the control card; a casing sourrounding the power distribution board and the switch and control cards; and signal distribution means mounted on the switch card and the control card for the transmission of control signals between the control card and the switch card.

### Summary of the Invention

It is an object of the present invention to simplify the electrical distribution within a motor vehicle.

An electrical distribution system for a motor vehicle in accordance with the present invention comprises a power distribution board having an electrical connection means for connection to a power supply and to one or more electrical loads; a switch card extending away from, and electrically connectable with, the power distribution board, and having electrically operable switch means mounted thereon for switching the power supplied to the or each electrical load from the power supply; a control card extending away from, and electrically connectable with, the power distribution board, having an electrical connection means thereon for receiving and transmitting electrical signals, and having control means mounted thereon for controlling the operation of the switch means dependent on signals received at the electrical connection means on the control card; a casing surrounding the power distribution board and the switch and control cards; and signal distribution means mounted on the switch card and the control card and the power distribution board for the transmission of control signals between the control card and the switch card.

The present invention provides a modular arrangement for power and signal distribution which reduces wiring harness complexity, provides easier installation in a motor vehicle, and enables a reduction in the number of variants.

The present invention is a modification of the arrangement described in EP-A-0900700, incorporated herein by reference.

### Brief Description of the Drawings

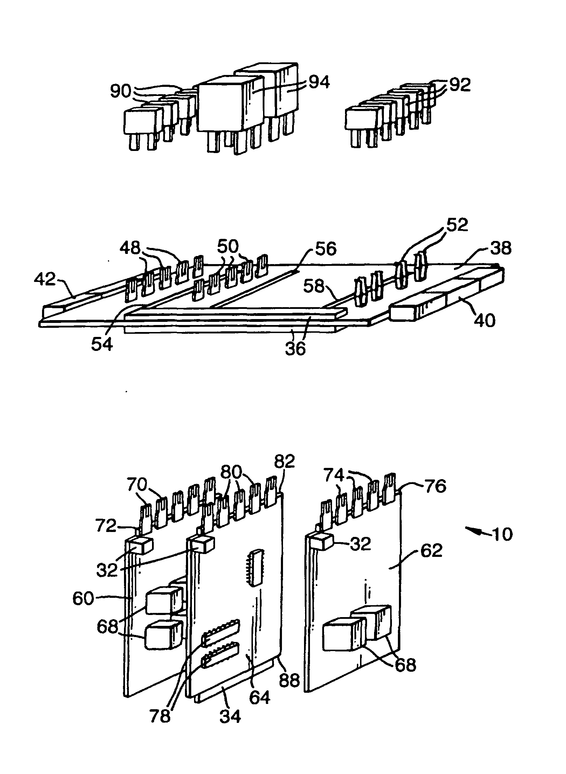

The present invention will now be described, by way of example, with reference to the accompanying drawing in which the sole figure is an exploded view of an electrical distribution system in accordance with the present invention.

### Description of the Preferred Embodiment

Referring to the sole figure, the electrical distribution system 10 for use in a motor vehicle comprises a power distribution board 38 having an electrical connector 40,42 at either end. One 42 of the electrical connectors is connectable with the vehicle storage battery (not shown). The other electrical connector 40 is connectable with electrical loads (not shown) in the motor vehicle. Alternatively, both connectors 40,42 may be connected to the battery and to electrical loads. Further, the connectors 40,42 may be located at other positions on the power distribution board 38. Electrical fuse contacts 48,52 and relay contacts 50 are mounted on the power distribution board 38. These contacts 48-52 are connected to electrical contacts (not shown) in the electrical connectors 40,42 by way of electrically conductive lines (not shown) on the board 38. Openings 54,56,58 are formed in the board 38 adjacent the contacts 48-52 on the board. The power board 38 is preferably a printed circuit board, but may alternatively be formed from stamped metal.

First and second switch cards 60,62 and a control card 64 extend away from the power board 38 in a direction substantially perpendicular to the power board. The cards 60-64 are preferably substantially rigid printed circuit boards. The first and second switch cards 60,62 have one or more relays 68 mounted thereon which are electrically connected with electrically conductive lines (not shown) formed on the cards. Electrical fuse contacts 70 are positioned at one end 72 of the first switch card 60 and are connected with the relays 68 on the first card by way of the lines on the card. When the system 10 is assembled, the fuse contacts 70 project through the opening 54 in the power board 38 and align with the fuse contacts 48 adjacent thereto. Electrical fuse contacts 74 are positioned at one end 76 of the second switch card 62 and are connected with the relays 68 on the second card by way of the lines on the card. When the system 10 is assembled, the fuse contacts 74 project through the opening 58 in the power board 38 and align with the fuse contacts 52 adjacent thereto. The control card 64 has one or more microcomputers 78 mounted thereon which are electrically connected with electrically conductive lines (not shown) formed on the card 64. Electrical relay contacts 80 are positioned at one end 82 of the control card 64 and are connected with the microcomputers 78 on the card by way of the lines on the card. When the system 10 is assembled, the relay contacts 80 project through the opening 56 in the power board 38 and align with the relay contacts 50 adjacent thereto. The lines on the control card 64 extend to the other end 88 of the card and electrically connect with an electrical connector 34 mounted on the control card. The electrical connector 34 is connectable with electrical lines within the motor vehicle for signals being transmitted from and received by the system 10 to electrical components in the vehicle.

In use, electrical fuses 90 electrically connect the fuse contacts 48 on the power board 38 with the fuse contacts 70 on the first switch card 60; electrical fuses 92 electrically connect the fuse contacts 52 on the power board 38 with the fuse contacts 74 on the second switch card 62; and relays 94 electrically connect the relay contacts 50 on the power board 38 with the relay contacts 80 on the control card 64. Any suitable mechanical connecting means may additionally be used to mechanically secure the cards 60-64 to the power board 38.

Signal distribution from the control card 64 to the switch cards 60,62, and from the switch cards to the control card, is by way of signal distribution means 32, 36 mounted on the cards. In one embodiment, the signal distribution means 36 may be an electrical bus, with the corresponding signal distribution means 32 on the cards 60-64 being appropriate electrical connectors which electrically connect with the bus. In an alternative arrangement, the signal distribution means 36 may be an optical light guide, with the signal distribution means 32 on the cards 60-64 being appropriate optical transmitters/receivers which optically connect with the light guide. The electrical bus or the optical light guide 36 is mounted on the power distribution board 38.

The relays 68,94 may be replaced by any other suitable electrically controllable switching devices, such as MOSFETs. The fuses 90,92 may be replaced by any other suitable overload disconnection system, such as circuit breakers. The microcomputers 78 may be replaced by any other suitable form of logic control means or semiconductor control device. The electrical connectors 34,40,42 may be replaced by any other suitable electrical connection means.

The electrical distribution system 10 of the present invention may be mounted inside a casing substantially as described in the above mentioned GB patent application no. 9718892.4. Alternatively, the power board 38 and each card 60-64 may be mounted inside individual casings which are mechanically connected together to electrically and mechanically connect the cards with the board.

With the present invention, power distribution and signal distribution for a motor vehicle can be combined within a casing which can be assembled before installation on a motor vehicle. Power distribution from a vehicle battery to the electrical loads in a vehicle is by way of the power board 38, the fuses 90 and the relays 68,94. The microcomputers 78 receive and send signals by way the electrical connector 34 to monitor and control the operation of the relays 68,94, and to monitor and control the operation of other electrical components in the motor vehicle. The present invention therefore provides a modular arrangement for combining power and signal distribution, but maintains isolation between the two distribution systems. Such an arrangement reduces the complexity of vehicle wiring harnesses and provides for easier installation in a motor vehicle.

The present invention also lends itself for easy modification dependent on the vehicle within which the system is to be installed, and dependent on customer requirements for the vehicle, thereby reducing variants.

## Claims

1. An electrical distribution system for a motor vehicle comprising a power distribution board (38) having an electrical connection means (42,44) for connection to a power supply and to one or more electrical loads; a switch card (60) extending away from, and electrically connectable with, the power distribution board, and having electrically operable switch means (68) mounted thereon for switching the power supplied to the or each electrical load from the power supply; a control card (64) extending away from, and electrically connectable with, the power distribution board, having an electrical connection means (34) thereon for receiving and transmitting electrical signals, and having control means (78) mounted thereon for controlling the operation of the switch means dependent on signals received at the electrical connection means on the control card; a casing surrounding the power distribution board and the switch and control cards; and signal distribution means (32,36) mounted on the switch card and the control card and the power distribution board for the transmission of control signals between the control card and the switch card.

2. An electrical distribution system as claimed in Claim 1, wherein electrical fuses (90) provide the electrical connection between the switch card (60) and the power distribution board (38).

3. An electrical distribution system as claimed in Claim 2, wherein the power distribution board (38) has fuse contacts (48) mounted thereon, and the switch card (60) has corresponding fuse contacts (70) which extend through an opening (54) in the power distribution board.

4. An electrical distribution system as claimed in Claim 2 or Claim 3, wherein electrical relays (94) provide the electrical connection between the control card (64) and the power distribution board (38).

5. An electrical distribution system as claimed in Claim 4, wherein the power distribution board (38) has relay contacts (50) mounted thereon, and the control card (64) has corresponding relay contacts (80) which extend through an opening (56) in the power distribution board.

6. An electrical distribution system as claimed in any one of Claims 1 to 5, further comprising one or more additional switch cards (62) extending away from, and electrically connectable with, the power distribution board (38), and having electrically operable switch means (68) mounted thereon for switching the power supplied to the one or more electrical loads from the power supply.

7. An electrical distribution system as claimed in Claim 6, wherein electrical fuses (92) provide the electrical connection between the second switch card (62) and the power distribution board (38).

8. An electrical distribution system as claimed in any one of Claims 1 to 7, wherein the signal distribution means comprises an electrical bus (36), and an electrical connector (32) mounted on the or each switch card (60,62) and on the control card (64), the electrical connectors making an electrical connection with the electrical bus.

9. An electrical distribution system as claimed in Claim 8, wherein the electrical bus (36) is mounted on the power distribution board (38).

10. An electrical distribution system as claimed in any one of Claims 1 to 7, wherein the signal distribution means comprises an optical light guide, and an optical receiver/transmitter mounted on the or each switch card and on the control card, the optical transmitters/receivers making an optical connection with the optical light guide.

11. An electrical distribution system as claimed in Claim 10, wherein the optical light guide is mounted on the power distribution board.

## Patentansprüche

1. Elektrisches Verteilungssystem für ein Kraftfahrzeug mit einer Platine (38) zur Leistungsverteilung mit einem elektrischen Verbindungsmittel (42, 44) zur Verbindung mit einer Stromversorgung und mit einer oder mehr elektrischen Lasten; einer Schaltkarte (60), die von der Platine zur Leistungsverteilung absteht, mit ihr elektrisch verbindbar ist und ein darauf montiertes elektrisch betätigbares Schaltmittel (68) aufweist, um die an die oder jede elektrische Last von der Stromversorgung gelieferte Leistung umzuschalten; einer Steuerkarte (64), die von der Platine zur Leistungsverteilung absteht, mit ihr elektrisch verbindbar ist und darauf ein elektrisches Verbindungsmittel (34) aufweist, um elektrische Signale zu empfangen und zu senden, und ein darauf montiertes Steuermittel (78) aufweist, um die Operation des Schaltmittels in Abhängigkeit von am elektrischen Verbindungsmittel auf der Steuerkarte empfangenen Signalen zu steuern; einem Gehäuse, das die Platine zur Leistungsverteilung und die Schalt- und Steuerkarten umgibt; und einem Signalverteilungsmittel (32, 36), das auf der Schaltkarte und der Steuerkarte und der Platine zur Leistungsverteilung montiert ist, für die Übertragung von Steuersignalen zwischen der Steuerkarte und der Schaltkarte.

2. Elektrisches Verteilungssystem nach Anspruch 1,
worin elektrische Sicherungen (90) die elektrische Verbindung zwischen der Schaltkarte (60) und der Platine (38) zur Leistungsverteilung herstellen.

3. Elektrisches Verteilungssystem nach Anspruch 2,
worin die Platine (38) zur Leistungsverteilung darauf montierte Sicherungskontakte (48) aufweist und die Schaltkarte (60) entsprechende Sicherungskontakte (70) aufweist, die sich durch eine Öffnung (54) in der Platine zur Leistungsverteilung erstrecken.

4. Elektrisches Verteilungssystem nach Anspruch 2 oder Anspruch 3,
worin elektrische Relais (94) die elektrische Verbindung zwischen der Steuerkarte (64) und der Platine (38) zur Leistungsverteilung herstellen.

5. Elektrisches Verteilungssystem nach Anspruch 4,
worin die Platine (38) zur Leistungsverteilung darauf montierte Relaiskontakte (50) aufweist und die Steuerkarte (64) entsprechende Relaiskontakte (80) aufweist, die sich durch eine Öffnung (56) in der Platine zur Leistungsverteilung erstrecken.

6. Elektrisches Verteilungssystem nach einem der Ansprüche 1 bis 5, ferner mit einer oder mehr zusätzlichen Schaltkarten (62), die von der Platine (38) zur Leistungsverteilung abstehen, mit ihr elektrisch verbindbar sind und darauf montierte elektrisch betätigbare Schaltmittel (68) aufweisen, um die an die eine oder mehr elektrische Lasten von der Stromversorgung gelieferte Leistung umzuschalten.

7. Elektrisches Verteilungssystem nach Anspruch 6,
worin elektrische Sicherungen (92) die elektrische Verbindung zwischen der zweiten Schaltkarte (62) und der Platine (38) zur Leistungsverteilung herstellen.

8. Elektrisches Verteilungssystem nach einem der Ansprüche 1 bis 7,
worin das Signalverteilungsmittel einen elektrischen Bus (36) und einen elektrischen Verbinder (32) aufweist, der auf der oder jeder Schaltkarte (60, 62) und auf der Steuerkarte (64) montiert ist, wobei die elektrischen Verbinder eine elektrische Verbindung mit dem elektrischen Bus herstellen.

9. Elektrisches Verteilungssystem nach Anspruch 8,
worin der elektrische Bus (36) auf der Platine (38) zur Leistungsverteilung montiert ist.

10. Elektrisches Verteilungssystem nach einem der Ansprüche 1 bis 7,
worin das Signalverteilungsmittel einen optischen Lichtleiter und einen optischen Sender/Empfänger aufweist, der auf der oder jeder Schaltkarte und auf der Steuerkarte montiert ist, wobei die optischen Sender/ Empfänger eine optische Verbindung mit dem optischen Lichtleiter herstellen.

11. Elektrisches Verteilungssystem nach Anspruch 10,
worin der optische Lichtleiter auf der Platine zur Leistungsverteilung montiert ist.

## Revendications

1. Système de distribution électrique pour un véhicule à moteur, comprenant : un panneau de distribution électrique (38) comprenant des moyens de connexion électrique (42, 44) en vue d'une connexion à une alimentation électrique et à une ou plusieurs charges électriques ; une carte de commutation (60) s'étendant en s'éloignant du panneau de distribution électrique et pouvant être connectée à celui-ci, et sur laquelle sont montés des moyens de commutation actionnables électriquement (68) afin de commuter l'électricité envoyée vers les ou chacune des charges électriques depuis l'alimentation électrique ; une carte de commande (64) s'étendant en s'éloignant du panneau de distribution électrique, pouvant être connectée électriquement à celui-ci, sur laquelle sont montés des moyens de connexion électrique (34) afin de recevoir et d'émettre des signaux électriques, et sur laquelle est monté un moyen de commande (78) permettant de commander le fonctionnement des moyens de commutation en fonction des signaux reçus au niveau des moyens de connexion électrique sur la carte de commande ; un boîtier entourant le panneau de distribution électrique et les cartes de commutation et de commande ; et des moyens de distribution de signaux (32, 36) montés sur la carte de commutation, et sur la carte de commande et sur le panneau de distribution électrique en vue de la transmission de signaux de commande entre la carte de commande et la carte de commutation.

2. Système de distribution électrique tel que revendiqué dans la revendication 1, dans lequel des fusibles électriques (90) assurent la connexion électrique entre la carte de commutation (60) et le panneau de distribution électrique (38).

3. Système de distribution électrique tel que revendiqué dans la revendication 2, dans lequel le panneau de distribution électrique (38) comporte des contacts de fusibles (48) montés sur celui-ci, tandis que la carte de commutation (60) comporte des contacts de fusibles correspondants (70) qui dépassent à travers une ouverture (54) dans le panneau de distribution électrique.

4. Système de distribution électrique tel que revendiqué dans la revendication 2 ou la revendication 3, dans lequel des relais électriques (94) assurent la connexion électrique entre la carte de commande (64) et le panneau de distribution électrique (38).

5. Système de distribution électrique tel que revendiqué dans la revendication 4, dans lequel le panneau de distribution électrique (38) comprend des contacts de relais (50) montés sur celui-ci, tandis que la carte de commande (64) comprend des contacts de relais correspondants (80) qui dépassent à travers une ouverture (56) dans le panneau de distribution électrique.

6. Système de distribution électrique tel que revendiqué dans l'une quelconque des revendications 1 à 5, comprenant en outre une ou plusieurs cartes de commutation (62) supplémentaires qui s'étendent en s'éloignant du panneau de distribution électrique (38), et peuvent être connectées à celui-ci, et sur lesquelles sont montés des moyens de commutation actionnables électriquement (68) afin de commuter l'électricité envoyée vers les ou chacune des charges électriques depuis l'alimentation électrique.

7. Système de distribution électrique tel que revendiqué dans la revendication 6, dans lequel des fusibles électriques (92) assurent la connexion électrique entre la seconde carte de commutation (62) et le panneau de distribution électrique (38).

8. Système de distribution électrique tel que revendiqué dans l'une quelconque des revendications 1 à 7, dans lequel le moyen de distribution de signaux comprend un bus électrique (36), et un connecteur électrique (32) monté sur les ou chacune des cartes de commutation (60, 62) et sur la carte de commande (64), les connecteurs électriques assurant une connexion électrique avec le bus électrique.

9. Système de distribution électrique tel que revendiqué dans la revendication 8, dans lequel le bus électrique (36) est monté sur le panneau de distribution électrique (38).

10. Système de distribution électrique tel que revendiqué dans l'une quelconque des revendications 1 à 7, dans lequel le moyen de distribution de signaux comprend un guide de lumière optique, ainsi qu'un récepteur/émetteur optique monté sur les ou chacune des cartes de commutation et sur la carte de commande, les récepteurs/émetteurs optiques assurant une connexion optique avec le guide de lumière optique.

11. Système de distribution électrique tel que revendiqué dans la revendication 10, dans lequel le guide de lumière optique est monté sur le panneau de distribution électrique.
